# EUROPEAN PATENT APPLICATION

(11) **EP 3 951 024 A1**
(43) Date of publication of application: **09.02.2022**
(21) Application number: 20776441.6
(22) Date of filing: 24.03.2020
(51) Int. Cl.: C30B 29/38, C23C 16/455, C30B 25/20, H01L 21/205

(54) **DEVICE AND METHOD FOR MANUFACTURING GROUP III NITRIDE SUBSTRATE**

(30) Priority: 28.03.2019 JP 2019063351
(71) Applicant: SHIN-ETSU CHEMICAL CO., LTD., Tokyo 100-0004 (JP)
(72) Inventor: KUBOTA, Yoshihiro, Annaka-shi, Gunma 379-0195 (JP); NAGATA, Kazutoshi, Annaka-shi, Gunma 379-0195 (JP)
(74) Representative: Vossius & Partner Patentanwälte Rechtsanwälte mbB
(86) International application number: PCT/JP2020/012954
(87) International publication number: WO 2020/196494

(57) **Abstract**

A group III nitride substrate manufacturing apparatus according to the present invention includes: a rotating susceptor (3) for holding and rotating a seed crystal (2) in a reaction container (1); a heating means (9) for heating the seed crystal (2); a revolving susceptor (4) for placing thereon and revolving the rotating susceptor (3); a first gas ejection port (6) for ejecting a gas of a chloride of a group III element at a predetermined angle with respect to the direction of the axis of rotation of the revolving susceptor (4), a second gas ejection port (7) for ejecting a nitrogen-containing gas at the predetermined angle with respect to the direction of the axis of rotation of the revolving susceptor (4), and a third gas ejection port (8) for ejecting an inert gas from between the first gas ejection port (6) and the second gas ejection port (7) and at the predetermined angle with respect to the direction of the axis of rotation of the revolving susceptor (4); and an exhaust means (5) for exhausting gas. A group III nitride substrate manufacturing method according to the present invention can be performed by using the manufacturing apparatus of the present invention. According to the present invention, it is possible to provide a manufacturing apparatus and method which can produce a uniform, good group III nitride crystal substrate.

## Description

### Technical Field

The present invention relates to an apparatus and method for manufacturing a low-cost, high-quality group III nitride substrate, such as an AlN or GaN substrate, and in particular to an apparatus and method for manufacturing a GaN crystal substrate.

### Background Art

A crystalline AlN substrate and a crystalline GaN substrate have a wide band gap, exhibit extremely short-wavelength luminescence, have high pressure resistance, and have excellent high-frequency properties, and are expected to be used in a laser, a power device, a high-frequency device, etc. At present, however, crystal growth of AlN or GaN is difficult to achieve, and it is difficult to obtain an inexpensive crystalline AlN or GaN substrate having high properties. Therefore, a crystalline AlN substrate and a crystalline GaN substrate are not widespread as of yet.

For example, in the case of a GaN substrate, a bulk GaN substrate, obtained through the growth of GaN crystal in a liquid such as liquid ammonia (liquid ammonia method) or a Na flux, generally has high properties. However, such a method can only produce a substrate having a diameter as small as 2 to 4 inches. In addition, the substrate is very expensive and has limited application. On the other hand, a metalorganic chemical vapor deposition method (MOCVD method) or a hydride vapor phase epitaxy method (HVPE method, THVPE method, or the like), which involves gas-phase heteroepitaxial growth of GaN on a sapphire substrate or an AlN substrate, can produce a relatively-inexpensive, large-diameter GaN film. However, a high-quality product has not yet been obtained; therefore, there is a demand for an improvement in such a method. In particular, a hydride vapor phase epitaxy method (HVPE method, THVPE method), because of the characteristics of the material gas, is expected to have the advantages of less contamination by carbon, a higher film-forming rate by at least an order of magnitude, and higher properties and productivity as compared to the MOCVD method that uses an organic metal. At present, however, due to blocking of a gas ejection port or a reaction container with GaN as a product or NH₄Cl as a by-product, the reaction cannot be continued stably. Further, it is difficult to increase the size of a production apparatus. The hydride vapor phase epitaxy method is currently practiced only on a small laboratory scale at most at the level of a small quartz glass tube. Moreover, there is a considerable variation in the quality and the thickness of a GaN crystal substrate produced. Thus, the current method has very poor mass productivity. There is, therefore, a demand to establish a novel large-scale, mass-production method which can perform a uniform reaction and can provide a product free of a variation in the quality.

A method as described in patent document 1, for example, is known as a current hydride vapor phase epitaxy method. In the method of patent document 1, GaCl is used as a Ga source in carrying out a HVPE reaction. Using a double tube for supplying a halogen gas (GaCl) and a seal gas (inert gas), the halogen gas is supplied from the central tube of the double tube, while the seal gas is supplied from the outer tube. Further, ammonia gas is supplied from the gap between the double tube and a growth chamber (reaction tube). A GaN crystal, or the like can be produced by the method. The method of patent document 1 uses the double tube to surround the halogen gas with the seal gas to prevent a too-early reaction and deposition of a reaction product, thereby preventing a decrease in the crystal growth rate and blocking of the reaction system. However, this method is only effective for a very small apparatus of the laboratory level, in particular for an apparatus with a very small gap between the double tube and the growth chamber (reaction tube). This is because the method of patent document 1 supplies ammonia gas directly onto a crystal growth substrate from the gap between the double tube and the growth chamber (reaction tube). If a large-scale apparatus is used for the purpose of mass production, the space, that is, the gap between the double tube and the growth chamber (reaction tube), through which ammonia gas flows, should necessarily have a very large cross-sectional flow passage area. Accordingly, the flow rate of ammonia gas will be very low, and lower than the flow rates of other gases supplied from the double tube. Therefore, ammonia gas in a sufficient amount for the reaction may not reach the crystal growth substrate, resulting in a failure to perform the reaction in a normal manner. Thus, a heterogeneous reaction is likely to occur due to non-uniform mixing of the reactants.

Patent document 2 describes an invention concerning an HVPE method, which is similar to that of patent document 1. The invention is directed to a method for producing AlN whose reaction rate is higher than that of GaN. The main purpose of the invention is to prevent blocking of the tip of a reaction gas ejection nozzle. According to the invention, in a method for producing an aluminum nitride such as AlN by reacting an aluminum halide gas, such as AlCl₃, with a nitrogen-source gas, such as NH₃, on a substrate held in a reaction zone, the reaction gases, namely the halide gas and the nitrogen-source gas, are allowed to flow to the reaction zone with a barrier gas, such as argon gas, intervening between the reaction gases. The reaction gases are brought into contact and reacted with each other on the substrate. More specifically, while allowing the aluminum halide gas, such as AlCl₃, to flow from the central tube of a double tube provided in a chamber comprised of a quartz reaction tube, and allowing the nitrogen-source gas, such as NH₃, to flow from the gap between the double tube and the chamber (quartz reaction tube), or from a separate tube, N₂ gas, for example, is allowed to flow from the outer tube of the double tube as a barrier gas intervening between the aluminum halide gas and the nitrogen-source gas, thereby preventing blocking of the tip of the double tube that supplies the reaction gases. The invention described in patent document 2 is little different from the method described in patent document 1, the invention described in patent document 2 is however not suited for a large-scale mass production apparatus for the same reasons as described above with reference to patent document 1 and may be feasible with a small-scale apparatus, in the case where the nitrogen-source gas is allowed to flow from the gap between the double tube of the reaction gas ejection ports, from the outer tube of which the halide gas is supplied, and the chamber (quartz reaction tube). In the case where the nitrogen-source gas, such as NH₃, is allowed to flow from a separate tube, the halide gas and the nitrogen-source gas are likely to form parallel flows. Accordingly, the reaction gases are likely to be mixed non-uniformly, and therefore a uniform product is unlikely to be obtained.

Patent document 3, like patent documents 1 and 2, discloses an HVPE method. In the method of patent document 3, a nitrogen-source gas is supplied from a separate tube, and two barrier gases, ejected from upper and lower ports with respect to a base substrate, are supplied in different amounts and at different linear velocities in order to prevent blocking of the nozzle and to enhance the reaction yield. However, it is difficult for this method to supply a halide gas and a nitrogen-source gas uniformly onto the base substrate. Thus, the reaction gases are likely to be mixed non-uniformly on the base substrate, and therefore the resulting GaN crystal film is likely to have a non-uniform quality and a non-uniform thickness. The methods described in patent documents 1 to 3, which may somewhat differ in their purposes, are thus all basically for a small-scale reaction system, and are not suited for mass production.

Patent document 4 describes a THVPE method using GaCl₃ as a Ga source. Though not shown diagrammatically, the document states that the gas outlet shown in FIGS. 10 and 11 may have a double-tube structure so that a gallium chloride gas is discharged from the inner tube, and a barrier gas is discharged from the outer tube (reaction tube). The document state that by surrounding the flow of the gallium chloride gas, exiting the gas outlet, with the flow of the barrier gas, the gallium chloride gas is prevented from reacting with NH₃ before the gallium chloride gas reaches a growth zone. This method, like the methods of patent documents 1 to 3, may be useful to a small-scale apparatus, but is not suited for mass production that requires a larger scale of reaction. This is because in the method described in patent document 4, the reaction tube, constituting the reaction chamber, serves part of the double tube. Therefore, as with the methods of patent documents 1 to 3, a sufficiently high flow velocity of the barrier gas needs to be used in order for the barrier gas to prevent the gallium chloride from reacting with NH₃ before the gallium chloride gas reaches a growth zone. Thus, it is necessary to use an enormous amount of the barrier gas. The use of an enormous amount of the barrier gas greatly dilutes the reaction gases into an extremely low concentration, resulting in a large reduction in the reaction rate. If the barrier gas is used in a small amount, then interdiffusion between gallium chloride and NH₃ will occur due to insufficient barrier function of the barrier gas, and a reaction product will grow at the outlets of the gas tubes for gallium chloride and NH₃, causing blocking of the gas tubes as well as a non-uniform or abnormal reaction. This makes it difficult to continue the reaction over a long period of time.

The above patent documents thus disclose the technique of surrounding one of reaction material gases, such as a halide gas (GaCl, GaCl₃) and a nitrogen-source gas (NH₃), with a seal gas in order to prevent blocking of the reaction system, including material gas tubes and the outlet and wall surface of a reaction tube (reaction chamber), a reduction in the yield, etc. due to problems with the reaction material gases and to a non-uniform reaction between the gases. The patent documents propose the use of a double tube and a barrier gas as a method to achieve the surrounding of a reaction gas. However, the methods described in the patent documents have the drawbacks described above, and a method for manufacturing a group III nitride substrate having high properties has not yet been established. Low-cost mass production of such a substrate has not been successful thus far.

### Citation List

### Patent Literature

Patent document 1: Published Japanese Translation No. 2002-542142 of the PCT International Publication
Patent document 2: Japanese Patent Laid-Open Publication No. 2006-114845
Patent document 3: Japanese Patent Laid-Open Publication No. 2014-69987
Patent document 4: International Publication No. WO 2017/159311

### Summary of Invention

### Technical Problem

The present invention has been made in view of the above situation. It is therefore an object of the present invention to provide a manufacturing apparatus and method which can produce a uniform, good group III nitride crystal substrate. Solution to Problem

In order to achieve the above object, the present invention provides the following apparatus and method for manufacturing a group III nitride substrate.
[1] An apparatus for manufacturing a group III nitride substrate, including: a rotating susceptor for holding and rotating a seed crystal in a reaction container; a heating means for heating the seed crystal; a revolving susceptor for placing thereon and revolving the rotating susceptor; a first gas ejection port for ejecting a gas of a chloride of a group III element at a predetermined angle with respect to the direction of the axis of rotation of the revolving susceptor, a second gas ejection port for ejecting a nitrogen-containing gas at the predetermined angle with respect to the direction of the axis of rotation of the revolving susceptor, and a third gas ejection port for ejecting an inert gas from between the first gas ejection port and the second gas ejection port and at the predetermined angle with respect to the direction of the axis of rotation of the revolving susceptor; and an exhaust means for exhausting gas.
[2] The apparatus for manufacturing a group III nitride substrate as described in [1] above, including a concentric multiplex tube in which the first gas ejection port is surrounded by the third gas ejection port, and the third gas ejection port is surrounded by the second gas ejection port.
[3] The apparatus for manufacturing a group III nitride substrate as described in [1] or [2] above, wherein the predetermined angle is selected from the range of not less than 5° and not more than 85°.
[4] The apparatus for manufacturing a group III nitride substrate as described in any one of [1] to [3] above, wherein the inner wall of the reaction container is covered with a material which does not react with the gases ejected from the first gas ejection port, the second gas ejection port and the third gas ejection port, or with a reaction product of these gases.
[5] The apparatus for manufacturing a group III nitride substrate as described in any one of [1] to [4] above, further including a pressure adjustment means for adjusting the pressure in the reaction container to a negative pressure lower than atmospheric pressure.
[6] A method for manufacturing a group III nitride substrate, including: holding a seed crystal on a rotating susceptor rotating in a reaction container; heating the seed crystal with a heating means; placing the rotating susceptor on a revolving susceptor, and rotating the revolving susceptor; ejecting a gas of a chloride of a group III element from a first gas ejection port at a predetermined angle with respect to the direction of the axis of rotation of the revolving susceptor, ejecting a nitrogen-containing gas from a second gas ejection port at the predetermined angle with respect to the direction of the axis of rotation of the revolving susceptor, and ejecting an inert gas from a third gas ejection port at the predetermined angle with respect to the direction of the axis of rotation of the revolving susceptor; and exhausting gas with an exhaust means.
[7] The method for manufacturing a group III nitride substrate as described in [6] above, wherein the gases are ejected from a concentric multiplex tube in which the first gas ejection port is surrounded by the third gas ejection port, and the third gas ejection port is surrounded by the second gas ejection port.
[8] The method for manufacturing a group III nitride substrate as described in [6] or [7] above, wherein the predetermined angle is selected from the range of not less than 5° and not more than 85°.
[9] The method for manufacturing a group III nitride substrate as described in any one of [6] to [8] above, further including adjusting the pressure in the reaction container to a negative pressure lower than atmospheric pressure by using a pressure adjustment means.
[10] The method for manufacturing a group III nitride substrate as described in any one of [6] to [9] above, wherein the group III nitride is gallium nitride,
   wherein the seed crystal is a SCAM substrate, or a gallium nitride substrate produced by a method selected from a MOCVD method, a Na flux method, a liquid ammonia method, and a hydride vapor phase epitaxy method,
   wherein the gas of a chloride of a group III element is gallium trichloride or gallium chloride,
   wherein the nitrogen-containing gas is ammonia, and
   wherein the inert gas is argon or nitrogen.

### Advantageous Effects of Invention

According to the present invention, it is possible to obtain a uniform, good group III nitride crystal substrate.

### Brief Description of Drawings

FIG. 1 is a schematic view of a group III nitride substrate manufacturing apparatus according to an embodiment of the present invention.
FIG. 2 is a schematic view of the group III nitride substrate manufacturing apparatus shown in FIG. 1 as viewed in the direction of the axis of rotation of a revolving susceptor.
FIG. 3 is a diagram showing a cross-section of a first gas ejection port, a second gas ejection port and a third gas ejection port.
FIG. 4 is a diagram showing an arrangement of rotating susceptors in Example 1.

### Description of Embodiments

### [Group III Nitride Substrate Manufacturing Apparatus]

A group III nitride substrate manufacturing apparatus according to an embodiment of the present invention will now be described. It is to be noted that the group III nitride substrate manufacturing apparatus of the present invention is not limited by the embodiment.

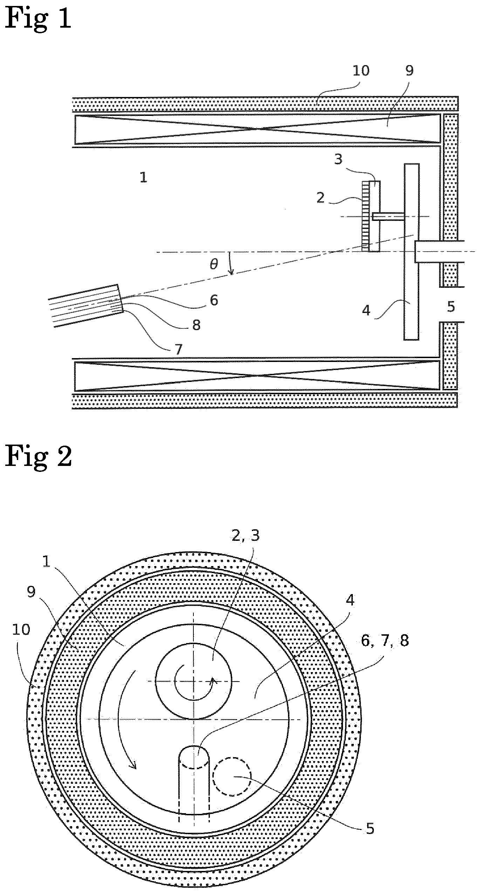

FIGS. 1 and 2 show a group III nitride substrate manufacturing apparatus according to an embodiment of the present invention. FIG. 1 is a schematic view of the group III nitride substrate manufacturing apparatus according to an embodiment of the present invention, and FIG. 2 is a schematic view of the group III nitride substrate manufacturing apparatus shown in FIG. 1 as viewed in the direction of the axis of rotation of a revolving susceptor.

The group III nitride substrate manufacturing apparatus according to an embodiment of the present invention includes: a rotating susceptor 3 for holding and rotating a seed crystal 2 in a reaction container 1; a heating means 9 for heating the seed crystal 2, a revolving susceptor 4 for placing thereon and revolving the rotating susceptor 3; a first gas ejection port 6 for ejecting a gas of a chloride of a group III element at a predetermined angle θ with respect to the direction of the axis of rotation of the revolving susceptor 4, a second gas ejection port 7 for ejecting a nitrogen-containing gas at the predetermined angle θ with respect to the direction of the axis of rotation of the revolving susceptor 4, and a third gas ejection port 8 for ejecting an inert gas from between the first gas ejection port 6 and the second gas ejection port 7 and at the predetermined angle θ with respect to the direction of the axis of rotation of the revolving susceptor 4; and an exhaust means 5 for discharging a gas. The group III nitride substrate manufacturing apparatus according to an embodiment of the present invention, having the above construction, can manufacture a high-quality, large-sized group III nitride substrate at a low cost.

### (Seed Crystal)

There is no particular limitation on the seed crystal 2 as long as it can grow a group III nitride film by a hydride vapor phase epitaxy method (e.g., HVPE method or THVPE method). The group III nitride is, for example, AlN or GaN. In the case of GaN, it is preferred to use as a seed substrate a ScAlMgO₄ (SCAM) substrate, or a GaN substrate produced by a method selected from a MOCVD method, a Na flux method, a liquid ammonia method, and a hydride vapor phase epitaxy method. The seed crystal is generally placed on the rotating susceptor 3 via a heat-resistant adhesive such as alumina, or in a set-in manner. At least GaCl₃ and/or GaCl, an inert gas such as N₂, and NH₃ are supplied onto the seed crystal to perform a reaction to thicken a GaN crystal film on the seed crystal.

A GaN crystal cannot be obtained if hydride vapor phase epitaxy is performed without using a seed crystal. When Si, SiC, AlN, GaAs, sapphire, or the like is used as a seed crystal, because of a considerable difference in lattice constant and thermal expansion coefficient between such a seed crystal and a GaN crystal, the resulting GaN crystal sometimes has many defects and poor properties, or is considerably warped. Therefore, when the group III nitride is GaN, the seed crystal 2 is preferably one whose lattice constant and thermal expansion coefficient are close or equal to those of a GaN substrate, such as a ScAlMgO₄ (SCAM) substrate or the above-described GaN substrate. The use of such a seed crystal 2 can produce a GaN crystal which has a large diameter and yet is not warped, has little defects, and has high properties.

### (Rotating Susceptor)

The rotating susceptor 3 holds the seed crystal 2, and rotates on its axis. A heat-resistant ceramic, such as PBN or corundum, may be used for the rotating susceptor 3. The seed crystal 2 is held on the rotating susceptor 3 using a heat-resistant adhesive such as alumina. While there is no particular limitation on the rotational speed of the rotating susceptor 3, it is preferably 10 to 40 rpm. When the rotational speed of the rotating susceptor 3 is 10 to 40 rpm, the resulting group III nitride crystal substrate has a better uniformity and, in addition, the rotating susceptor 3 can be rotated in a more stable manner.

### (Heating Means)

The heating means 9 heats the seed crystal 2. The heating can promote the growth of a group III nitride on the seed crystal 2. The heating temperature of the seed crystal 2 is preferably 900 to 1400°C. When the heating temperature of the seed crystal 2 is 900 to 1400°C, the crystal growth rate of the group III nitride can be made high, and degradation of the grown group III nitride crystal can be prevented.

### (Revolving Susceptor)

The revolving susceptor 4 is to place the rotating susceptor 3 on it, and rotates on its axis. A heat-resistant ceramic, such as PBN or corundum, may be used for the revolving susceptor 4. Either one rotating susceptor 3 or two or more rotating susceptors 3 may be placed on the revolving susceptor 4. The rotating susceptor(s) 3 revolves when the revolving susceptor 4 rotates. By combining the rotation of the rotating susceptor 3 with the revolution of the rotating susceptor 3 caused by the rotation of the revolving susceptor 4, it becomes possible to grow a uniform group III nitride film on the seed crystal 2. While there is no particular limitation on the rotational speed of the revolving susceptor 4, it is preferably about half of the rotational speed of the rotating susceptor 3, specifically 5 to 20 rpm. When the rotational speed of the revolving susceptor 4 is about half of the rotational speed of the rotating susceptor 3, the revolving susceptor 4 can be rotated in a more stable manner. The direction of rotation of the revolving susceptor 4 may be the same as or different from the direction of rotation of the rotating susceptor 3. However, the direction of rotation of the revolving susceptor 4 is preferably the same as the direction of rotation of the rotating susceptor 3.

### (Gas Ejection Ports)

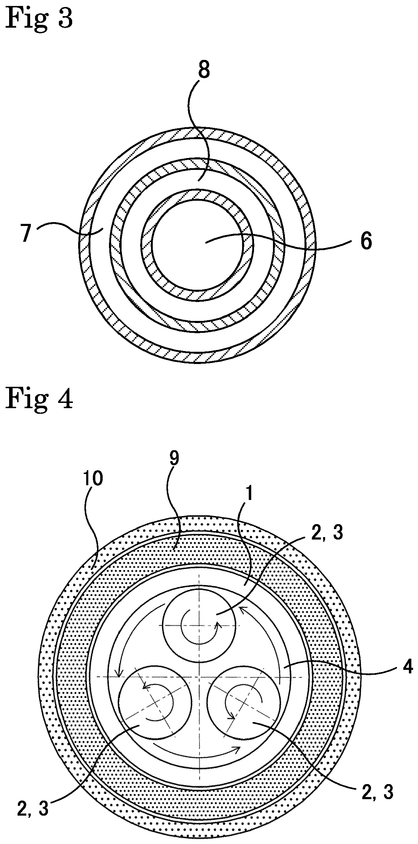

As described above, the group III nitride substrate manufacturing apparatus according to an embodiment of the present invention includes the first gas ejection port 6, the second gas ejection port 7, and the third gas ejection port 8. The first gas ejection port 6 ejects a gas of a chloride of a group III element at a predetermined angle θ with respect to the direction of the axis of rotation of the revolving susceptor 4. Examples of the gas of a chloride of a group III element include AlCl₃ gas, GaCl gas, and GaCl₃ gas. The second gas ejection port 7 ejects a nitrogen-containing gas at the predetermined angle θ with respect to the direction of the axis of rotation of the revolving susceptor 4. NH₃ gas is an example of the nitrogen-containing gas. It is to be noted that N₂ gas herein falls into the category of an inert gas, and is not treated as a nitrogen-containing gas. The third gas ejection port 8 ejects an inert gas from between the first gas ejection port 6 and the second gas ejection port 7 and at the predetermined angle θ with respect to the direction of the axis of rotation of the revolving susceptor 4. Examples of the inert gas include N₂ gas and argon gas. The inert gas can prevent the gas of a chloride of a group III element and the nitrogen-containing gas from reacting immediately after the gases are ejected from the first gas ejection port 6 and the second gas ejection port 7. This can prevent blocking of the first gas ejection port 6 and the second gas ejection port 7. From the viewpoint of more securely preventing the gas of a chloride of a group III element and the nitrogen-containing gas from reacting immediately after the gases are ejected from the first gas ejection port 6 and the second gas ejection port 7, it is preferred to use a concentric multiplex tube in which the first gas ejection port 6 is surrounded by the third gas ejection port 8, and the third gas ejection port 8 is surrounded by the second gas ejection port 7, as shown in FIG. 3. In such a concentric multiplex tube, each gas ejection port is preferably comprised of a dedicated tube because the ejection angle of each gas can be equalized, and a symmetrical reaction field can be formed. The diameter of each gas ejection port and the linear velocity of each gas are determined such that the best uniform mixing of the gases is performed on the rotating susceptor. It is also possible to use a quadplex or higher multiplex (e.g. quadplex, pentaplex or hexaplex) tube depending on the size of the apparatus or for adjustment of a gas flow. For example, when the flow of NH₃ spreads out too wide from the above-described triplet tube, a reaction product is likely to deposit on the wall of the reaction container. In order to prevent this problem, it is possible to use a quadplex tube having an additional outermost port for ejecting an inert gas such as N₂.

The first gas ejection port 6, the second gas ejection port 7, and the third gas ejection port 8 eject the respective gases at the predetermined angle θ with respect to the direction of the axis of rotation of the revolving susceptor 4. This enables the growth of a uniform group III nitride film on the seed crystal 2. From such a viewpoint, the predetermined angle θ is preferably selected from the range of not less than 5° and not more than 85°. When the angle θ is not less than 5°, the reaction gases can be supplied uniformly onto the surface of the rotating susceptor, thereby making it possible to make the thickness and the properties of the resulting group III nitride crystal film uniform. When the angle θ is not more than 85°, a group III nitride crystal can be prevented from depositing on and adhering to a shaft, the revolving susceptor 4, etc. rather than the surface of the rotating susceptor 3. This can prevent the occurrence of rotation or revolution trouble. The angle θ may be appropriately selected from the above range in consideration of the number and the arrangement of rotating susceptors 3 on the revolving susceptor 4, the linear velocities of the gases, the speed of the rotation, the speed of the revolution, the exhaust velocity, etc. From the above-described viewpoints, the predetermined angle θ is more preferably not less than 10° and not more than 60°, even more preferably not less than 20° and not more than 45°.

Owing to a synergistic effect of the ejection of each gas at the predetermined angle θ and the rotation and the revolution of the rotating susceptor 3, very uniform dispersion and mixing of the gases on the rotating susceptor 3 becomes possible. Accordingly, when a plurality of rotating susceptors 3 are placed on the revolving susceptor 4, a high-yield uniform crystal growth reaction can be performed on every rotating susceptor 3. In addition, troubles can be eliminated not only at the gas ejection ports but also in other portions of the apparatus which have been in trouble with deposition of a reaction product and blocking with the reaction product. This makes it possible to continue the reaction over a long period of time, and to obtain a group III nitride crystal having excellent properties.

Since the target group III nitride substrate is to be used as a semiconductor substrate, various metal impurities must be avoided as much as possible in performing hydride vapor phase epitaxy. In a hydride vapor phase epitaxy process, which is generally performed using GaCl and/or GaCl₃ and ammonia as reaction materials, a large amount of hygroscopic NH₄Cl is produced as a reaction by-product, and this by-product is likely to adhere to the inner wall of the reaction container, etc. Every time the reaction container is opened, a chloride ion is generated from the adhering NH₄Cl in the presence of moisture in the air. When the reaction container is made of a metal, such chloride ions will cause corrosion of the metal, which may result in contamination of a group III nitride crystal with the metal. Therefore, it is preferred that the inner wall of the reaction container 1 be covered with a material which does not react with the gases ejected from the first gas ejection port 6, the second gas ejection port 7 and the third gas ejection port 8, or with a reaction product of these gases. In particular, a hydride vapor phase epitaxy process is preferably performed after coating the inner wall of the apparatus, members, parts, etc. with a material which inherently does not react with the reaction gases, for example, a ceramic such as quartz glass or zirconia, and/or a high-melting metal such as Mo or W. The coating is preferably performed by thermal spraying. The resulting group III nitride substrate is free of metal contamination, and exhibits high properties when a device is produced. During the vapor phase epitaxial reaction, the inner wall of the reaction container and the inner wall of the exhaust means are preferably kept heated e.g. at a temperature of not less than 500°C using the heating means 9. This can reduce the attachment of a reaction by-product to the inner wall. From the viewpoint of keeping the inner wall of the reaction container 1 heated, the outer side of the heating means 9 is preferably covered with a heat insulating material 10.

### (Exhaust Means)

The exhaust means 5 exhausts gas from the reaction container. An unnecessary gas can be discharged from the reaction container and, in addition, the pressure in the reaction container can be kept constant.

### (Pressure Adjustment Means)

The group III nitride substrate manufacturing apparatus according to an embodiment of the present invention preferably includes a pressure adjustment means for adjusting the pressure in the reaction container 1 to a negative pressure lower than atmospheric pressure. The pressure in the reaction container 1 is preferably 200 to 600 Torr. When the pressure in the reaction container 1 is 200 to 600 Torr, a group III nitride substrate having a better film thickness distribution and having no variation in the properties can be obtained. The conventional hydride vapor phase epitaxy process is generally performed at a positive pressure slightly higher than atmospheric pressure in order to increase, if only a little, the reaction rate. The use of a positive pressure, however, has the drawback of a poor film thickness uniformity. According to the group III nitride substrate manufacturing apparatus of this embodiment, the supply of the gases at a predetermined angle with respect to the direction of the axis of rotation of the revolving susceptor, together with the satellite motion of the rotating susceptor, i.e. its rotation combined with its revolution caused by the revolving susceptor, enables very uniform mixing of the reaction gases on the rotating susceptor, thereby enabling a very high reaction efficiency and a very high reaction rate. While the resulting group III nitride crystal is generally satisfactory e.g. in terms of the variation in the film thickness and properties, a flatter group III nitride substrate having a better film thickness distribution and a less variation in the properties can be obtained by performing the epitaxy process while maintain the pressure in the reaction container at a negative pressure slightly lower than atmospheric pressure.

### [Group III Nitride Substrate Manufacturing Method]

The group III nitride substrate manufacturing method of the present invention includes: holding a seed crystal on a rotating susceptor rotating in a reaction container; heating the seed crystal with a heating means; placing the rotating susceptor on a revolving susceptor, and rotating the revolving susceptor; ejecting a gas of a chloride of a group III element from a first gas ejection port at a predetermined angle with respect to the direction of the axis of rotation of the revolving susceptor, ejecting a nitrogen-containing gas from a second gas ejection port at the predetermined angle with respect to the direction of the axis of rotation of the revolving susceptor, and ejecting an inert gas from a third gas ejection port at the predetermined angle with respect to the direction of the axis of rotation of the revolving susceptor; and exhausting gas with an exhaust means. The group III nitride substrate manufacturing method of the present invention, having the above process features, can manufacture a high-quality, large-sized group III nitride substrate at a low cost.

The group III nitride substrate manufacturing method of the present invention can be performed by using, for example, the group III nitride substrate manufacturing apparatus according to an embodiment of the present invention. In particular, the method includes: holding the seed crystal 2 on the rotating susceptor 3 rotating in the reaction container 1; heating the seed crystal 2 with the heating means 9; placing the rotating susceptor 3 on the revolving susceptor 4, and rotating the revolving susceptor 4; ejecting a gas of a chloride of a group III element from the first gas ejection port 6 at a predetermined angle θ with respect to the direction of the axis of rotation of the revolving susceptor 4, ejecting a nitrogen-containing gas from the second gas ejection port 7 at the predetermined angle θ with respect to the direction of the axis of rotation of the revolving susceptor, and ejecting an inert gas from the third gas ejection port 8 at the predetermined angle θ with respect to the direction of the axis of rotation of the revolving susceptor 4; and exhausting gas with the exhaust means 5.

As with the group III nitride substrate manufacturing apparatus according to an embodiment of the present invention, it is preferred to use a concentric multiplex tube, in which a first gas ejection port is surrounded by a third gas ejection port, and the third gas ejection port is surrounded by a second gas ejection port, also in the group III nitride substrate manufacturing method of the present invention.

As with the group III nitride substrate manufacturing apparatus according to an embodiment of the present invention, the predetermined angle is preferably selected from the range of not less than 5° and not more than 85° also in the group III nitride substrate manufacturing method of the present invention.

As with the group III nitride substrate manufacturing apparatus according to an embodiment of the present invention, the pressure in the reaction container is preferably adjusted by a pressure adjustment means to a negative pressure lower than atmospheric pressure also in the group III nitride substrate manufacturing method of the present invention.

As with the group III nitride substrate manufacturing apparatus according to an embodiment of the present invention, the group III nitride is preferably gallium nitride, the seed crystal is preferably a SCAM substrate, or a gallium nitride substrate produced by a method selected from a MOCVD method, a Na flux method, a liquid ammonia method, and a hydride vapor phase epitaxy method, the gas of a chloride of a group III element is preferably gallium trichloride or gallium chloride, the nitrogen-containing gas is preferably ammonia, and the inert gas is preferably argon or nitrogen also in the group III nitride substrate manufacturing method of the present invention.

### Examples

The following examples illustrate the present invention in greater detail and are not intended to limit the scope of the invention.

### [Example 1]

A stainless-steel reaction container 1 (having a very thin thermal-sprayed coating of zirconia on the inner surface) as schematically shown in FIG. 1, having an inner diameter of 1500 mm and a height of 1800 mm, equipped with a water-cooling jacket (not shown), an exhaust port 5, and a vacuum pump (not shown) provided downstream of the exhaust port, and surrounded by a mat-like heat insulating material 10 of alumina, was provided. The reaction container 1, in its interior, had a heating device 9 (inner diameter 1000 mm x height 1300 mm) comprised of a rod-like, cylindrical SiC heater, provided inside the heat insulating material 10, and a concentric triplet tube of PBN (pyrolytic boron nitride) having gas ejection ports (central tube, inner diameter 30 mm; second tube, inner diameter 40 mm; outermost tube, inner diameter 50 mm, configured to be capable of varying the angle θ of the gas ejection ports). On the other hand, a revolving susceptor 4 of PBN-coated graphite having a diameter of 520 mm, on which three rotating susceptors 3 of PBN having a diameter of 170 mm were placed at 120-degree intervals as shown in FIG. 4, was provided in the reaction container 1. Tile-shaped seed substrates, cut from a 2-inch GaN seed crystal substrate 2 produced by a liquid ammonia method, were bonded to the surface of each rotating susceptor with an alumina adhesive into a disk-like shape having a diameter of 6 inches, followed by heating to 1050°C with the SiC heater 9. At the same time, the revolving receptor 4 was rotated at 10 rpm, and the three rotating susceptors 3 were each rotated at 30 rpm by means of revolving gears. After confirming the stability of the temperature and the rotations, the vacuum pump connected to the exhaust port 5 was actuated, and GaCl₃ gas was supplied from the central tube 6 (first gas ejection port) of the triplet tube, NH₃ gas was supplied from the outermost tube 7 (second gas ejection port), and N₂ gas for prevention of blocking was supplied from the tube 8 (third gas ejection port) between the central tube and the outermost tube in such a manner as to maintain the pressure in the reaction container at 500 Torr to conduct a THVPE reaction for 95 hours, thereby obtaining a GaN crystal having an approximately uniform in-plane thickness of about 30 mm. Troubles such as blocking of each gas ejection port with GaN or with NH₄Cl as a by-product, deposition of such a substance on an area around the susceptors, etc. did not occur at all during the process. During the THVPE reaction, the gas ejection ports were adjusted with an angle adjuster to keep their angle at 30° with respect to the direction of the axis of rotation (axis of revolution) of the revolving susceptor. The resulting GaN crystal was machined by cylindrical grinding into a 6-inch size crystal, followed by slicing and polishing to obtain a substrate having a thickness of 625 µm. The FWHM (Full Width at Half Maximum) of the X-ray rocking curve for the (100) plane of the substrate was measured. As a result, for measured values at three arbitrary points on the plane, the average was 31 arcsec and the variation was 4 arcsec. Further, an observation of stacking fault with a monochrome cathode luminescence image revealed almost no fault in a surface layer of the GaN crystal. The results of the above measurement and observation indicate that the resulting GaN crystal is a variation-free, uniform, and good crystal substrate.

### [Comparative Example 1]

The reaction was performed in the reaction container of Example 1 under the same conditions as in Example 1 except that the revolving susceptor was not rotated, i.e. the three rotating susceptors were not revolved, while allowing the rotating susceptors to rotate at 30 rpm. After the THVPE reaction, the thickness of the resulting 6-inch GaN crystal varied greatly from 5 mm to 18 mm, and the GaN yield was very low. The GaN crystal was sliced and polished into a substrate having a thickness of 625 µm. The substrate was subjected to the above FWHM measurement. As a result, the average was 430 arcsec and the variation was 120 arcsec. The large values indicate that the crystal has a poor in-plane uniformity. Further, an observation of stacking fault with a monochrome cathode luminescence image revealed many faults in the surface of the GaN substrate. The results of Example 1 and Comparative Example 1 thus demonstrate a significant effect produced by the combination of the revolution of a rotating susceptor holding jig and the rotation of the rotating susceptor: the synergistic effect of the combination achieves uniform mixing of the reaction gases on the rotating susceptor, leading to the high-yield production of a variation-free, uniform, and good GaN crystal substrate.

### [Example 2]

Using the reaction container of Example 1, a so-called HVPE process was performed under the same conditions as in Example 1 except for changing the GaCl₃ gas to GaCl gas, and thickening the central tube of the triplet tube to adjust the linear velocity of the GaCl gas, supplied from the central tube, to be equal to the linear velocity of the GaCl₃ gas in Example 1. As in Example 1, troubles such as blocking of each gas ejection port with the product GaN or NH₄Cl, deposition of such a substance on an area around the susceptors, etc. did not occur during the process. The resulting GaN crystal had an approximately uniform in-plane thickness of about 12 mm. The resulting GaN crystal was processed into a substrate having a thickness of 5 µm as in Example 1. The FWHM of the X-ray rocking curve for the (100) plane of the substrate was measured. As a result, for measured values at three arbitrary points on the plane, the average was 52 arcsec and the variation was 5 arcsec. Further, an observation of stacking fault with a monochrome cathode luminescence image revealed almost no fault in a surface layer of the GaN crystal. The results of the above measurement and observation indicate that the resulting GaN crystal is a variation-free, uniform, and good crystal substrate.

### [Example 3]

The apparatus of Example 1 was rotated 90 degrees so that the susceptors faced vertically upward. While maintaining the positional relationship between the gas ejection ports, the rotating susceptors, the revolving susceptor, the exhaust port, etc., the gas ejection ports were adjusted with the angle adjuster so that they faced downward at an angle of 15° with respect to the direction of the axis of rotation of the revolving susceptor. The reaction was performed in otherwise the same manner as in Example 1 to obtain a GaN crystal having an approximately uniform in-plane thickness of about 35 mm. Troubles such as blocking of each gas ejection port with GaN or with NH₄Cl as a by-product, deposition of such a substance on an area around the susceptors, etc. did not occur during the process. The resulting GaN crystal was subjected to the same evaluations as in Example 1. In particular, the FWHM of the X-ray rocking curve for the (100) plane of the substrate was measured. As a result, for measured values at three arbitrary points on the plane, the average was 48 arcsec and the variation was 7 arcsec. Further, an observation of stacking fault with a monochrome cathode luminescence image revealed almost no fault in a surface layer of the GaN crystal. The results of the above measurement and observation indicate that the resulting GaN crystal is a variation-free, uniform, and good crystal substrate.

### [Example 4]

The process was performed under the same conditions as in Example 1 except for performing the reaction at atmospheric pressure without operating the vacuum pump. The in-plane thickness of the resulting GaN crystal varied greatly from 20 mm to 35 mm. The GaN crystal was subjected to the same measurement and evaluation as in Example 1. As a result, in the FWHM measurement, the average was 185 arcsec and the variation was 20 arcsec. Though the values are somewhat large, the data still indicates in-plane uniformity of the crystal. Further, an observation of stacking fault with a monochrome cathode luminescence image revealed almost no fault in the surface of the GaN substrate.

### Reference Signs List

- 1: reaction container
- 2: seed crystal
- 3: rotating susceptor
- 4: revolving susceptor
- 5: exhaust port
- 6: first gas ejection port
- 7: second gas ejection port
- 8: third gas ejection port
- 9: heating means
- 10: heat insulating material

## Claims

1. An apparatus for manufacturing a group III nitride substrate, comprising:
a rotating susceptor for holding and rotating a seed crystal in a reaction container;
a heating means for heating the seed crystal;
a revolving susceptor for placing thereon and revolving the rotating susceptor;
a first gas ejection port for ejecting a gas of a chloride of a group III element at a predetermined angle with respect to the direction of the axis of rotation of the revolving susceptor, a second gas ejection port for ejecting a nitrogen-containing gas at the predetermined angle with respect to the direction of the axis of rotation of the revolving susceptor, and a third gas ejection port for ejecting an inert gas from between the first gas ejection port and the second gas ejection port and at the predetermined angle with respect to the direction of the axis of rotation of the revolving susceptor; and
an exhaust means for exhausting gas.

2. The apparatus for manufacturing a group III nitride substrate according to claim 1, including a concentric multiplex tube in which the first gas ejection port is surrounded by the third gas ejection port, and the third gas ejection port is surrounded by the second gas ejection port.

3. The apparatus for manufacturing a group III nitride substrate according to claim 1 or 2, wherein the predetermined angle is selected from the range of not less than 5° and not more than 85°.

4. The apparatus for manufacturing a group III nitride substrate according to any one of claims 1 to 3, wherein the inner wall of the reaction container is covered with a material which does not react with the gases ejected from the first gas ejection port, the second gas ejection port and the third gas ejection port, or with a reaction product of these gases.

5. The apparatus for manufacturing a group III nitride substrate according to any one of claims 1 to 4, further comprising a pressure adjustment means for adjusting the pressure in the reaction container to a negative pressure lower than atmospheric pressure.

6. A method for manufacturing a group III nitride substrate, comprising:
holding a seed crystal on a rotating susceptor rotating in a reaction container;
heating the seed crystal with a heating means;
placing the rotating susceptor on a revolving susceptor, and rotating the revolving susceptor;
ejecting a gas of a chloride of a group III element from a first gas ejection port at a predetermined angle with respect to the direction of the axis of rotation of the revolving susceptor, ejecting a nitrogen-containing gas from a second gas ejection port at the predetermined angle with respect to the direction of the axis of rotation of the revolving susceptor, and ejecting an inert gas from a third gas ejection port at the predetermined angle with respect to the direction of the axis of rotation of the revolving susceptor; and
exhausting gas with an exhaust means.

7. The method for manufacturing a group III nitride substrate according to claim 6, wherein the gases are ejected from a concentric multiplex tube in which the first gas ejection port is surrounded by the third gas ejection port, and the third gas ejection port is surrounded by the second gas ejection port.

8. The method for manufacturing a group III nitride substrate according to claim 6 or 7, wherein the predetermined angle is selected from the range of not less than 5° and not more than 85°.

9. The method for manufacturing a group III nitride substrate according to any one of claims 6 to 8, further comprising adjusting the pressure in the reaction container to a negative pressure lower than atmospheric pressure by using a pressure adjustment means.

10. The method for manufacturing a group III nitride substrate according to any one of claims 6 to 9, wherein the group III nitride is gallium nitride,
wherein the seed crystal is a SCAM substrate, or a gallium nitride substrate produced by a method selected from a MOCVD method, a Na flux method, a liquid ammonia method, and a hydride vapor phase epitaxy method,
wherein the gas of a chloride of a group III element is gallium trichloride or gallium chloride,
wherein the nitrogen-containing gas is ammonia, and
wherein the inert gas is argon or nitrogen.
